# DEMANDE DE BREVET EUROPEEN

(11) **EP 2 112 471 A1**
(43) Date de publication de la demande: **28.10.2009**
(21) Numéro de dépôt: 08154967.7
(22) Date de dépôt: 22.04.2008
(51) Int. Cl.: G01C 19/56, G01D 11/24, G01P 1/02, H03H 9/10, B81B 7/00

(54) **Dispositif de montage pour composant électronique**

(71) Demandeur: Microcomponents AG, 2540 Grenchen/Granges (CH)
(72) Inventeur: Tinguely, Xavier, 2056, Dombresson (CH); Tran, Kim Dat, 2502, Bienne (CH); Schorderet, Alain, 1022, Chavannes-près-Renens (CH)
(74) Mandataire: Ravenel, Thierry Gérard Louis

(57) **Abrégé**

L'invention concerne un dispositif de montage (1) de composant électronique (2) comprenant un boitier externe (3). Ce boîtier est destiné à être relié à un circuit électrique extérieur via des moyens de contact (4) et est agencé pour contenir un support (5) sur lequel est fixé le composant électronique (2). Le support est agencé pour être relié aux moyens de contact du boitier externe par l'intermédiaire d'au moins une plage de contact (8) placée sur ledit support. Ladite plage de contact permet au composant électronique fixé sur ledit support d'être relié électriquement aux moyens de contact du boitier externe via des moyens de connexion (6). En particulier, il est prévu que les moyens de connexion et le support du composant électronique soient agencés de sorte que ledit support soit suspendu par lesdits moyens de connexion afin que ledit support reste mobile.

## Description

La présente invention concerne un dispositif de montage d'un composant électronique, ce dispositif de montage comprenant un boîtier externe relié à un circuit électrique extérieur via des moyens de contact et contient un support sur lequel est fixé le composant électronique. Le support est agencé pour être relié aux moyens de contact du boitier externe, via au moins une plage de contact placée sur ledit support par l'intermédiaire des moyens de connexion. Cela permet au composant électronique fixé sur ledit support d'être électriquement relié aux moyens de contact du boitier externe.

### Arrière plan technologique

Il est connu dans l'art antérieur des dispositifs de montage de composant électronique sous forme de boîtiers renfermant un support sur lequel un ou plusieurs composants électroniques sont fixés. A l'origine, ces composants étaient fixés rigidement directement sur le fond du boîtier. Néanmoins, ces constructions, bien que simples à réaliser, montrent des inconvénients dès lors que les composants fixés audit boîtier ne s'accommodent pas de cette rigidité.

En effet, le principal inconvénient de la fixation rigide du composant sur le boitier est que toutes les vibrations et tous les chocs appliqués sur le boîtier se répercutent sur le composant qui y est fixé. Or, ce qui est anodin pour des composants à transistors tels que des portes logiques, des mémoires ou des composants passifs, devient extrêmement fâcheux pour des composants sensibles. En effet, dans le cas de composants tels que des résonateurs ou des gyroscopes qui vibrent ou génèrent des vibrations afin de fournir des données ou de piloter un circuit, l'application de vibrations extérieures parasites sur le boîtier du circuit intégré entraine une dérive des paramètres de fonctionnement des composants.

C'est pourquoi il a été conçu des systèmes permettant une atténuation des vibrations.

Il existe ainsi dans l'art antérieur des inventions ayant pour but de résoudre les problèmes liés aux perturbations induites par des chocs mécaniques externes. Nous pouvons citer par exemple le brevet FR 2 692 719 qui utilise une feuille de matériau élastique placée au fond du boitier externe entre ledit fond du boitier et le composant électronique afin d'amortir les vibrations extérieures pouvant se transmettre au composant. Le composant électronique est alimenté électriquement par des fils de connexion.

Or, un des problèmes à un tel système réside dans le fait qu'il est nécessaire d'utiliser deux éléments distincts afin de réaliser d'une part la connexion électrique et d'autre part l'amortissement. Cela entraîne d'une part, la modification du boitier externe afin d'y placer les moyens d'amortissement et d'autre part, une augmentation de la complexité du système entrainant alors une augmentation des coûts de production.

### Résumé de l'invention

L'invention concerne un dispositif de montage de composant électronique qui pallie les inconvénients susmentionnés de l'art antérieur en permettant de réduire l'encombrement et la complexité du système d'amortissement tout en améliorant son efficacité et en limitant les coûts.

A cet effet, l'invention concerne un dispositif de montage comme cité ci-devant, qui se **caractérise en ce que** les moyens de connexion et le support du composant électronique sont agencés de sorte que ledit support est suspendu par lesdits moyens de connexion de sorte que ledit support reste mobile.

Un avantage du dispositif de montage de composant électronique selon l'invention est d'avoir un système d'amortissement simple. En effet, un seul élément est utilisé pour réaliser à la fois la connexion électrique et l'amortissement. Cet élément qui s'avère être les moyens de connexion permet de relier électriquement le composant électronique fixé au support aux plages de contact du boîtier externe et donc à un circuit électrique quelconque, et d'amortir élastiquement ledit support sur lequel est fixé ledit composant.

Cette double fonctionnalité des moyens de connexion est permise par les caractéristiques propres des matériaux des moyens de connexion utilisés.

De plus, cette simplicité du système amortisseur permet de ne pas modifier la structure du boitier externe, évitant ainsi des coûts de conception supplémentaires.
Des modes de réalisation avantageux font l'objet des revendications dépendantes 2 à 19.

### BREVE DESCRIPTION DES FIGURES

Les buts, avantages et caractéristiques du dispositif de montage d'un composant électronique apparaîtront plus clairement dans la description détaillée suivante d'au moins une forme de réalisation de l'invention donnée uniquement à titre d'exemple non limitatif et illustrée par les dessins annexés sur lequel :
- les figures 1a et 1b représentent de manière schématique le dispositif de montage de composant électronique selon la présente invention ;
- les figures 2a et 2b représentent de manière schématique une coupe transversale du dispositif de montage de composant électronique selon la présente invention ;
- les figures 3 et 4 représentent de manière schématique des vues respectivement de dessus et de dessous du dispositif de montage de composant électronique selon la présente invention utilisant un premier type de moyens de connexion ;
- la figure 5 représente de manière schématique une vue de dessus du dispositif de montage de composant électronique selon la présente invention utilisant un deuxième type de moyens de connexion ;
- la figure 6 représente de manière schématique une vue de dessous du dispositif de montage de composant électronique selon la présente invention utilisant un deuxième type de moyens de connexion, et
- la figure 7 représente de manière schématique le dispositif de montage de composant électronique selon la présente invention utilisant un système complémentaire d'amortissement.

### DESCRIPTION DETAILLEE

Dans la description suivante, toutes les parties du dispositif de montage d'un composant électronique qui sont bien connues de l'homme du métier dans ce domaine technique ne seront expliquées que de manière simplifiée.

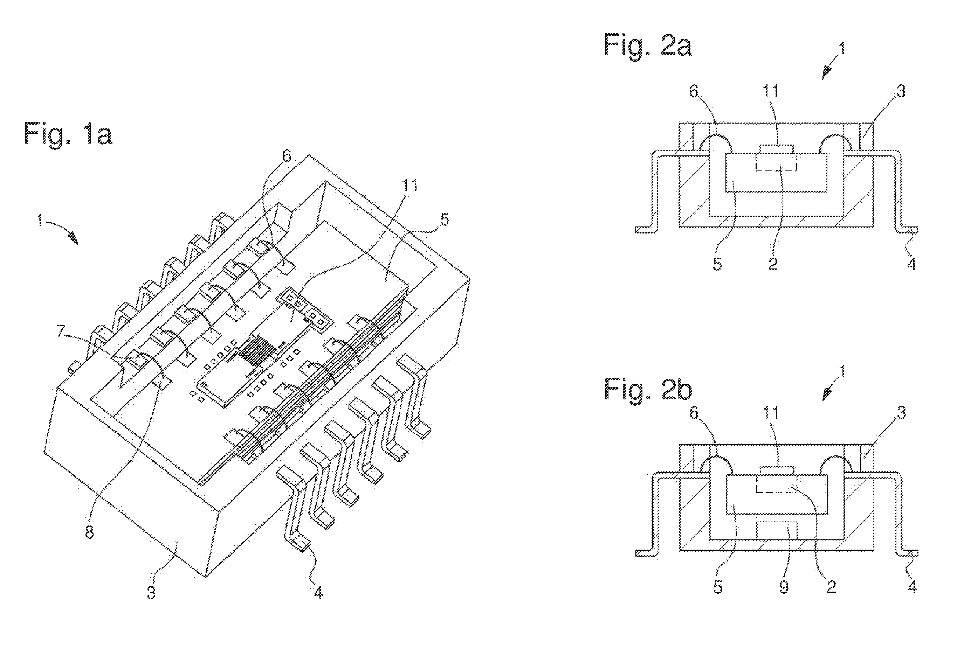

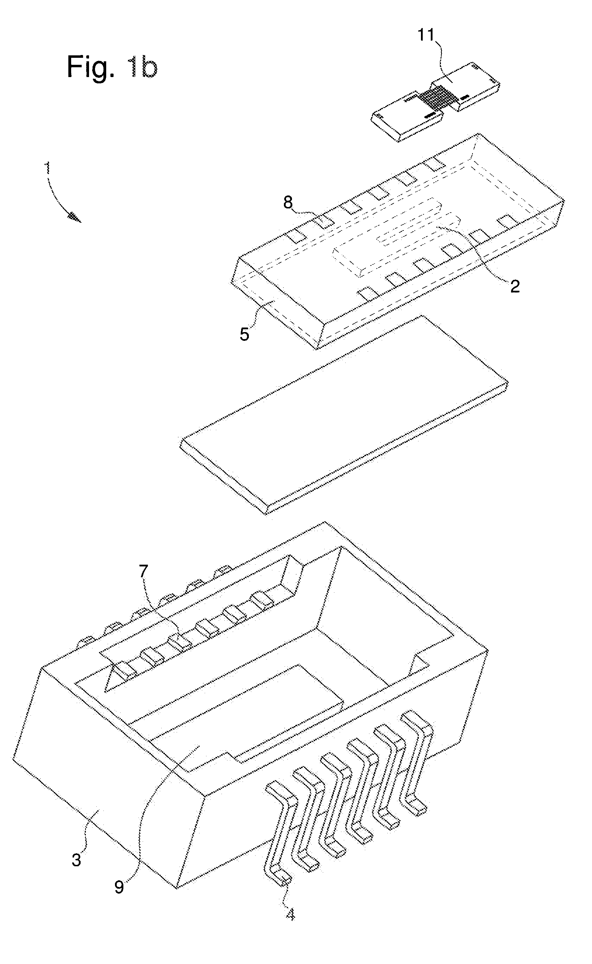

Les figures 1a et 1b représentent de manière schématique le dispositif de montage d'un composant électronique conforme à la présente invention dans sa forme de réalisation la plus simple. Ce dispositif de montage 1 dans lequel est monté un composant électronique 2 comprend un boîtier 3 externe relié à un circuit électrique extérieur via des moyens de contact 4. A l'intérieur du boîtier externe 3 est placé un support 5 sur lequel est fixé le composant électronique 2. Ce support 5 comprend des plages de contact 8 électriquement reliées au composant électronique 2. Ce dernier est électriquement relié aux moyens de contact 4 du boîtier externe 3 via des moyens de connexion 6 reliant les moyens de contact 4 aux plages de contact 8.

On pourrait également prévoir des plages de contact intermédiaires 7 situées dans le boîtier 3. Ainsi les moyens de connexion 6 relieraient les plages de connexion 8 du support 5 aux plages de contact 7 du boîtier 3, ces dernières étant électriquement reliées aux moyens de contact 4 dudit boîtier 3.

Le boîtier externe 3 a plusieurs fonctions dont la première est de réaliser la jonction électrique entre le composant électronique 2 qu'il renferme et le circuit électrique extérieur (non représenté) sur lequel le boîtier 3 est fixé. Le boîtier externe 3 peut également être utilisé en tant que dissipateur thermique afin d'évacuer l'énergie produite par effet joule par ledit composant 2, si cela s'avère nécessaire. Enfin le boîtier 3 a également une fonction protectrice puisqu'il est utilisé afin de protéger le composant électronique 2 des agressions de l'environnement extérieur pouvant être hostile tel que les chocs, la chaleur, l'humidité, etc. Ce boîtier est réalisé en matériaux rigides tel que de la céramique, des polymères à cristaux liquides (LCP ou Liquid Cristal Polymer en terminologie anglaise), du Polyestercarbonate (PEC) ou tout autre matériau utilisé dans le domaine des composants électroniques. Il est relié à un circuit électrique extérieur (non représenté) via des moyens de contact 4. Ces moyens de contact 4 sont, dans le cas présent, des pattes disposées symétriquement sur deux des flancs du boîtier 3. Néanmoins, ces moyens de contact peuvent prendre toutes les formes et toutes les dispositions possibles permettant de remplir la fonction de fixation électrique du boîtier 3 à un circuit électrique extérieur. On peut citer par exemple une connexion par matrice de billes où ce sont des billes situées sous le boîtier 3 qui assurent la connexion électrique avec le circuit électrique extérieur (Ball Grid Array ou BGA en terminologie anglo-saxonne).

A l'intérieur de ce boîtier 3 se trouve un support 5 sur lequel est fixé le composant électronique 2 souhaité. Ce support 5 a pour principale fonction de servir de base, qui sera suspendue, pour le composant 2 qui y sera fixé. Ce dernier deviendra, de ce fait, suspendu à son tour.

Le support 5 et les moyens de contact 4 du boîtier externe 3 sont électriquement reliés par des moyens de connexion. Cela permet au composant électronique fixé sur le support 5 d'être ainsi électriquement relié aux moyens de contact 4 du boîtier externe 3 et donc, par là même, à un circuit électrique extérieur.

Or, comme mentionné ci-dessus, les composants dits sensibles comme des résonateurs ou des gyroscopes nécessitent une certaine isolation vis-à-vis des vibrations et des chocs extérieurs. Pour cela, la présente invention se propose de pallier ce problème en utilisant les moyens de connexion 6 comme moyens de suspension. Cette utilisation des moyens de connexion 6 comme moyens de suspension permet un gain de place et une simplification du système puisqu'un seul élément est utilisé pour remplir deux fonctions : connexion électrique et suspension. Cela permet une réduction des coûts et de la durée de développement ainsi qu'une industrialisation plus simple. Cette fonction de suspension qui est réalisée les moyens de connexion 6 est le résultat des caractéristiques propres des matériaux utilisés.

En effet, les moyens de connexion ont une flexibilité permettant au support 5 sur lequel est fixé le composant électronique 2 d'être suspendu. Autrement dit, le support 5 se retrouve monté libre dans le boîtier externe 3, en suspension sans aucun appui. Seuls les moyens de connexion 6 assurent alors le maintien dudit support 5 en suspension.

En cas de chocs appliqués sur le boîtier externe 3, ceux-ci se répercutent à l'intérieur dudit boîtier 3. Or, les caractéristiques, notamment de flexibilité, des moyens de connexion 6 vont permettre à ces moyens de connexion de se déformer de manière plus ou moins accentuée et ainsi amortir une grande partie de ces vibrations extérieures afin de préserver le composant électronique 2 fixé sur le support 5 de ces vibrations parasites.

Selon une première variante de l'invention, comme on peut le voir sur les figures 1a et 1b les moyens de connexion 6 qui relient les moyens de contact 4 aux plages de contact 8, sont des fils de connexion 6 (bonds en terminologie anglo-saxonne) utilisant la technique de connexion par câblage (wire bonding en terminologie anglo-saxonne). Ces fils 6 ont une caractéristique de flexion qui dépend de la longueur, du diamètre et du matériau dont ces fils sont constitués. Ces fils de connexion 6 sont brasés de façon à former une arche, c'est-à-dire que l'une des extrémités du fil est brasée sur une plage de connexion 8 alors que l'autre extrémité est brasée sur un des moyens de contact 4 du boîtier externe 3 ou à une plage de connexion intermédiaire 7 du boîtier 3 si ce dernier en est pourvu.

Cette variante à l'avantage de la simplicité puisque tous les éléments composant ce dispositif de montage sont connus en soi, l'apport inventif résidant dans le fait d'utiliser lesdits fils de connexion 6 pour suspendre le support 5 sur lequel est fixé le composant électronique 2.

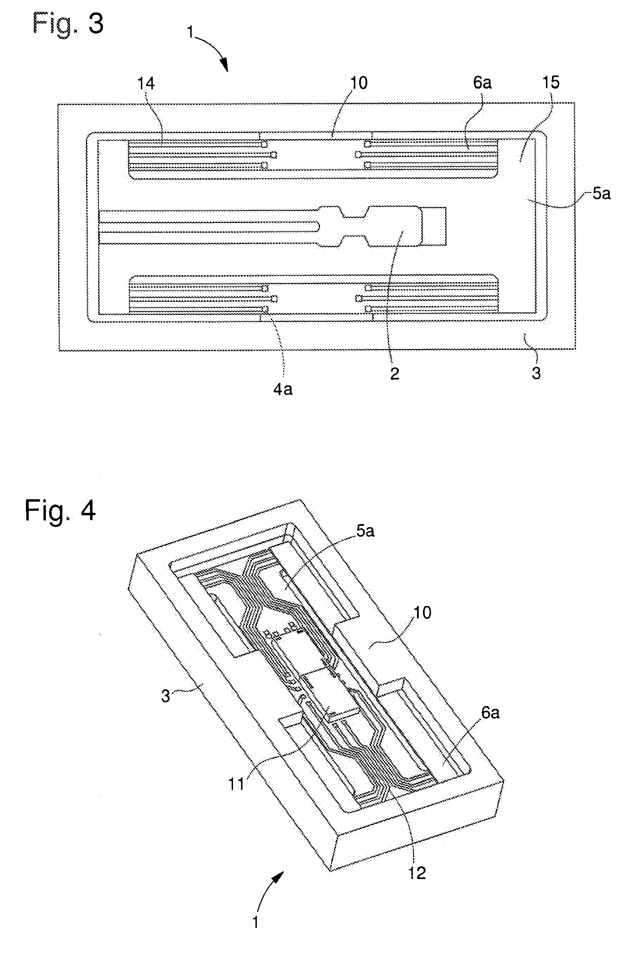

Selon une seconde variante de réalisation du dispositif de montage selon la présente invention, les moyens de connexion peuvent être réalisés à partir d'un circuit imprimé flexible 6a. Cette variante est représentée aux figures 3 et 4. Le circuit imprimé flexible 6a est un circuit imprimé classique, c'est-à-dire réalisé au moyen de pistes de cuivres insolées sur un substrat en matériau isolant. La différence entre un circuit imprimé flexible et son homologue classique c'est à dire rigide, vient du fait que dans le cas d'un circuit imprimé rigide, le substrat isolant est réalisé en bakélite ou résine époxy rigide alors que dans le cas d'un circuit imprimé flexible, le substrat est réalisé dans un matériau souple ayant une flexibilité permettant au circuit imprimé de se déformer.

Ainsi, les moyens de connexion prennent la forme d'une bande faite d'un matériau souple isolant sur laquelle sont insolées des pistes conductrices 14. Ces pistes 14 sont disposées de telle sorte que chacune d'entre elles relie une plage de contact 8 du support 5 avec un des moyens de contact du boîtier externe 3, afin de connecter électriquement lesdits moyens de contact 4 du boîtier externe 3 avec le composant électronique 2.

Là encore, ce moyen de connexion 6a offre une grande souplesse d'utilisation puisque la flexibilité du circuit imprimé flexible peut être modifiée en faisant varier l'épaisseur du substrat, le matériau constituant ce substrat, les dimensions en longueur et en largeur ainsi que la forme.

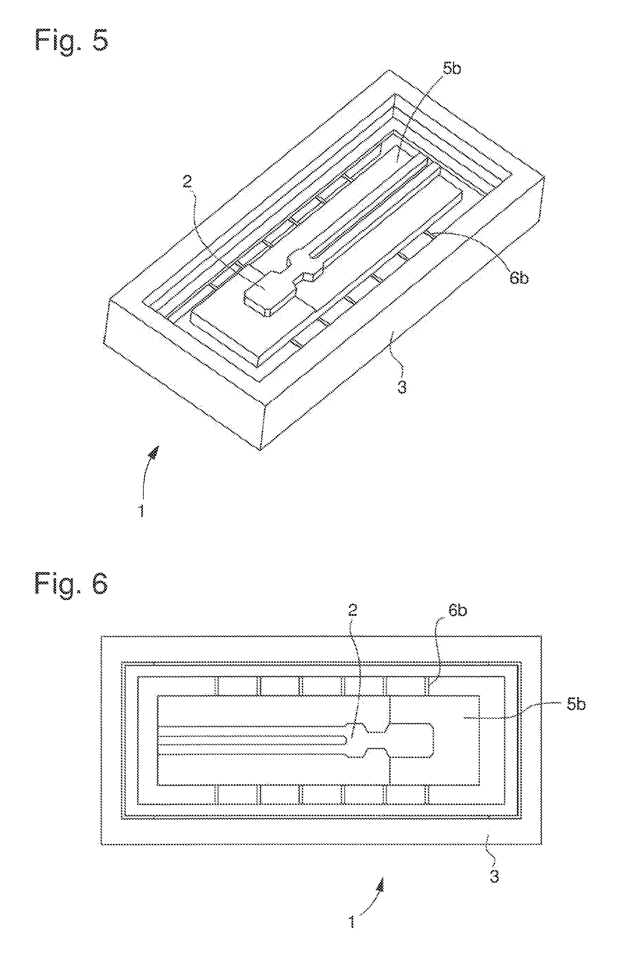

Selon une troisième variante de la présente invention représentée aux figures 5 et 6, un troisième type de moyen de connexion est envisagé. Dans le cas présent, les moyens de connexion utilisent le principe du soudage sur bande (TAB ou Tape Automated Bonding en terminologie anglo-saxonne). Ce principe consiste en un réseau de lamelles métalliques 6b disposées en étoile servant de support pour les plages de connexion du circuit électronique. Ainsi, chaque lamelle a une extrémité fixée à une plage de contact du composant électronique et son autre extrémité fixée à une plage de contact du circuit imprimé sur lequel est fixé le composant.

Dans le cas présent, les lamelles métalliques 6b sont chargées de relier les plages de contact du support 5a aux moyens de contact du boîtier externe 3. Ainsi le support 5a peut être fixé aux dites lamelles par-dessous ou par-dessus. De préférence, on utilisera la première solution consistant a poser le support 5a sur les lamelles.

L'avantage de ces lamelles réside dans le fait que cette technique est déjà prévue pour que le composant soit supporté par les moyens de connexions d'où une réduction des coûts et du temps de développement. Bien entendu, les exemples de réalisation cités ci-dessus ne sont donnés qu'à titre d'exemple et d'autres formes de réalisation peuvent être imaginées afin de remplir la fonction caractéristique de la présente invention.

S'il est bien évident que des variantes concernant les moyens de connexion sont possibles, il existe également d'autres variantes de l'invention qui sont intéressantes.

En effet, le support 5 est lui aussi un des éléments de la présente invention qui peut prendre des formes diverses présentant chacune des avantages non négligeables. Le support 5 a pour fonction principale de servir de base sur laquelle est fixé le composant électronique 2 ayant besoin d'être protégé des vibrations extérieures.

Une première variante de réalisation support 5 utilisé pour fixer le composant électronique est représentée aux figures 1a, 1b, 2a et 2b. Sur ces figures, on peut voir que le support sur lequel est fixé le composant électronique, se présente sous la forme d'un boîtier 5. Ce boîtier interne 5 est un parallélépipède évidé en son centre. Le composant électronique à isoler des vibrations tel qu'un gyroscope ou un résonateur par exemple, peut alors être monté à l'intérieur de ce boîtier interne 5.

Ce boîtier interne 5 peut être réalisé dans n'importe quel matériau généralement utilisé dans le domaine des composants électroniques. Le boîtier interne 5 est pourvu de plages de connexion 8 afin de connecter électriquement le composant électronique 2 aux moyens de contact 4 du boîtier externe 3. Bien entendu, des pistes conductrices sont agencées pour relier lesdites plages aux bornes de connexion dudit composant électronique 2.

Ces plages de connexion 8 sont par contre situées sur la face du boîtier interne 5 la plus adaptée aux moyens de connexion 6, 6a, 6b qui seront employés.

Effectivement, il est possible d'utiliser plusieurs variantes de moyens de connexion pour chaque type de support. Ainsi, dans le cas d'un support 5 ayant la forme d'un boîtier, l'utilisation des moyens de connexion 6 présentés auparavant, tels que l'utilisation de fils de connexion, de circuit imprimé flexible ou de lamelles, est envisageable.

Un avantage d'avoir deux boîtiers l'un dans l'autre est d'avoir une protection double puisque le composant situé à l'intérieur du boîtier interne 5 est à l'abri des chocs par deux niveaux de parois. De plus, un autre avantage est que certains types de protection peuvent être localisés. En effet, dans le cas d'un composant électronique devant être installé dans une enceinte sous vide, le fait d'avoir deux boîtiers permet de ne mettre sous une atmosphère de vide qu'un seul des deux boîtiers, à savoir celui dans lequel le composant se trouve. Ainsi, en cas de choc endommageant le boîtier externe 3, l'intégrité du vide dans lequel se trouve le composant n'est pas rompue.

Selon une seconde variante de réalisation du support et illustrée aux figures 3 et 4, le support 5 est une plaque 5a d'un matériau quelconque. De préférence, on utilisera un matériau courant dans les applications électroniques. Cette plaque qui sert de support 5 peut prendre n'importe quelle forme selon les contraintes d'encombrement à prendre en compte.

Cette plaque 5a possède des plages de contact situées sur sa face inférieure ou sa face supérieure. En effet, comme pour la variante précédente où le support 5 se présentait sous la forme d'un boîtier interne, la présente variante est compatible avec les trois variantes de moyens de connexion 6, 6a, 6b proposées auparavant. La plaque qui sert de support 5 sur lequel est fixé le composant électronique peut donc être suspendue par des fils de connexion, un ou des circuits imprimés flexibles ou même par un réseau de lamelles métalliques et par tout autre moyen de connexion envisageable.

Dans un mode de réalisation préféré représenté aux figures 3 et 4, cette plaque est rectangulaire. A chaque coin de cette plaque 5a, des saillies 15 s'étendent transversalement, deux saillies 15 situées du même coté selon l'axe longitudinal de ladite plaque formant ainsi un espace entre elles.

Cet espace est alors utilisé pour qu'un circuit imprimé flexible puisse y être glissé. A cet effet, les plages de contact sont situées au niveau des saillies 15. Ceci permet alors de placer le circuit imprimé flexible, possédant des pistes conductrices, dans l'espace formé par les deux saillies. Ainsi, le composant électronique 2, fixé sur ladite plaque 5a, est relié électriquement avec ledit circuit imprimé flexible.

Afin de soutenir et de fixer électriquement l'ensemble constitué par la plaque 5a et les deux circuits imprimés flexibles, un par coté de la plaque 5a, il est prévu un système situé au niveau du boîtier externe 3.

Pour ce faire, il est prévu de réaliser à l'intérieur du boîtier externe 3, deux excroissances 10. Ces excroissances 10 sont agencées l'une en face de l'autre au niveau des flancs longitudinaux du boîtier externe 3. Elles sont agencées pour ne pas se retrouver sous la plaque 5a, permettant à celle-ci de pouvoir se mouvoir librement selon une direction verticale, sans que ladite plaque 5a ne vienne à entrer en contact avec lesdites excroissances 10. Ces excroissances sont pourvues de plages de contact et de pistes conductrices 14, chaque piste conductrice 14 reliant une plage de contact 4a de l'excroissance avec un moyen de contact 4 du boîtier externe 3. Chaque plage de contact 4a est arrangée pour correspondre avec une piste conductrice d'un circuit imprimé flexible permettant alors une connexion électrique entre le composant électronique 2 et les moyens de contact 4 du boîtier externe 3.

Ainsi, la plaque se retrouve suspendue par les circuits imprimés flexibles en appui sur les excroissances 10. Bien entendu, le nombre d'excroissances ainsi que leur forme ne sont nullement figés. De même les emplacements des excroissances ne sont nullement fixes et peuvent donc être installés aux endroits convenant le mieux.

Comme dit auparavant, la spécificité de la présente invention est de se servir des moyens de connexion comme éléments d'amortissement pour isoler des vibrations extérieures le composant électronique que l'on désire placer dans le boîtier externe 3. Afin d'améliorer encore davantage l'amortissement, il peut être prévu d'adjoindre à la présente invention des éléments d'amortissement supplémentaires.

Ceux-ci prennent alors des formes diverses dont le principe générale consiste à faire reposer le support, sur lequel est fixé le composant électronique, sur un matériau élastique. Une variante connue est de faire reposer ledit support 5 sur une couche de matériau élastique tel que du gel par exemple.

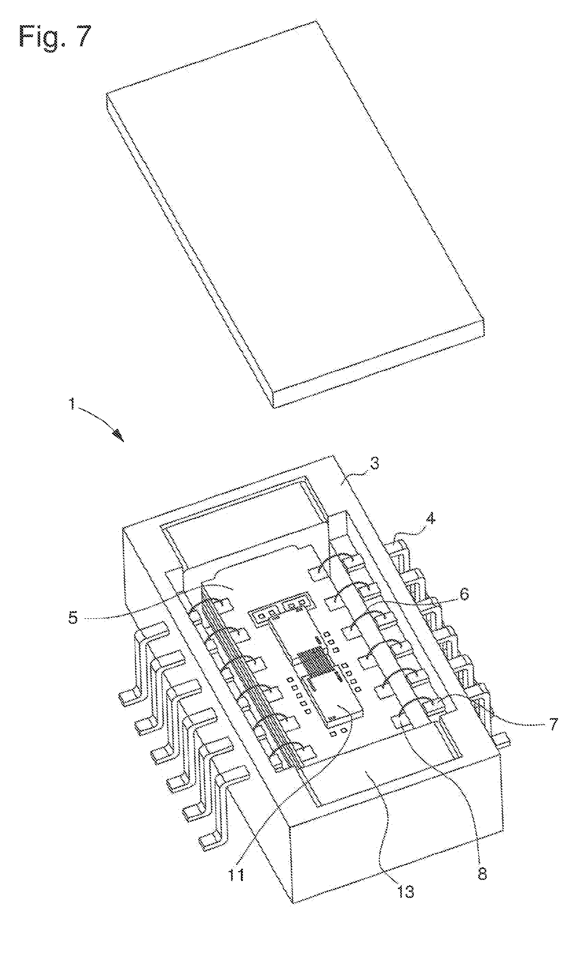

Comme visible sur la figure 7, les deux éléments 13 en matériau élastique servent à améliorer l'amortissement en fournissant une capacité supplémentaire à absorber les chocs. Ces éléments 13 se présentent sous la forme de deux supports élastiques. Ces supports sont disposés l'un en face de l'autre et sont fixés au support 5 du composant électronique. Préférentiellement, ces éléments 13 sont fixés en vis-à-vis par rapport à l'axe transversal dudit support 5 de composant électronique.

Ces deux éléments 13, réalisés préférentiellement en silicone, sont de forme parallélépipédique et agencés pour correspondre aux dimensions intérieures du boîtier externe 3. Sur l'un des flancs des éléments en matériau élastique, dont la longueur correspond à la largeur du boîtier externe 3, un évidement est réalisé. Cet évidement est agencé afin de permettre le parfait emboîtement du support 5 de composant électronique, au niveau de sa tranche transversale, dans ledit évidement. Ainsi, en faisant cela pour deux cotés opposés, le support 5 se retrouve fixé et supporté par lesdits éléments élastiques 13, comme représenté à la figure 7. Le tout est ensuite inséré dans le boîtier externe 3.

Bien entendu, cette utilisation de moyen supplémentaire d'amortissement fonctionne quel que soit le type de support 5 employé.

Toujours en ce qui concerne l'amortissement, il peut être prévu la mise en place d'un système de butée. Ce système sert à limiter l'amplitude du mouvement que peut faire le support 5 suspendu. En effet, avec le système utilisant les moyens de connexion 6 comme élément d'amortissement, le support 5 sur lequel est fixé le composant électronique se retrouve libre en mouvement à l'intérieur du boîtier externe 3. Cela permet entre autres de compenser les vibrations dues aux chocs appliqués au boîtier externe 3.

On comprendra alors que, plus le choc appliqué est violent, plus la compensation à effectuer doit être importante. Or, les moyens de connexion, particulièrement pour les fils de connexion, ont des limites quand à leur résistance. Cette limite peut être atteinte ou dépassée si des violents chocs devaient être appliqués de façon répétitive. Pour cela, comme illustré sur les figures 1b et 2b, il peut être prévu d'agencer sur le fond du boîtier externe 3 une butée 9, afin de limiter l'amplitude du mouvement dudit support 5. Cette butée 9 doit avoir une hauteur permettant la limitation du mouvement du support 5 afin de ne pas dépasser l'amplitude maximum sous risque de rupture.

De façon préférentielle, cette butée est un parallélépipède s'étendant suivant l'axe longitudinal du boîtier externe 3 et le matériau employé pour la réalisation de cette butée 9 est le même que celui utilisé pour le boîtier externe 3. Dans une version préférée, la butée 9 peut être recouvert d'une couche de matériau élastique afin d'absorber les chocs lorsque la butée 9 et le support 5 entrent en contact.

On a vu précédemment que le composant électronique est fixé à un support 5 qui est lui-même suspendu afin d'absorber les chocs. Ledit support 5 peut alors prendre des formes diverses telle que la forme d'une plaque ou d'un boîtier interne. On constate alors que le support 5 ne sert qu'à la fixation du composant électronique qu'il faut isoler et représente une perte de surface. Ainsi, ce support 5 peut aussi être prévu pour avoir une fonction de circuit imprimé afin d'y fixer d'autres composants électroniques afin de réduire la taille et la complexité du circuit électrique extérieur, celui sur lequel est fixé le boîtier externe 3.

Pour cela, un routage électrique 12 fait à partir de pistes conductrices peut y être installé comme visible à la figure 4. Ceci permet la fixation d'autres composants 11 tels que des composants à montage en surface (CMS ou SMD pour Surface Mounted Device en langue anglo-saxonne). L'un des avantages est de permettre à ces composants CMS d'être intégrés sur le support 5 afin que ces derniers ne soient pas montés sur le circuit électrique extérieur. Par exemple, il pourrait s'agir de composants qui quelle que soit l'application désirée, sont toujours associés au composant électronique qui est à isoler des vibrations. Cela permet une moindre complexité du routage électrique dudit circuit électrique externe.

On comprendra que diverses modifications et/ou améliorations et/ou combinaisons évidentes pour l'homme du métier peuvent être apportées aux différents modes de réalisation de l'invention exposé ci-dessus sans sortir du cadre de l'invention défini par les revendications annexées.

## Revendications

1. Dispositif de montage (1) de composant électronique (2) comprenant un boitier externe (3) destiné à être relié à un circuit électrique extérieur via des moyens de contact (4) et étant agencé pour contenir un support (5) sur lequel est fixé le composant électronique, ledit support est agencé pour être relié aux moyens de contact du boitier externe par l'intermédiaire d'au moins une plage de contact (8) placée sur ledit support, ladite plage de contact permettant au composant électronique fixé sur ledit support d'être relié électriquement aux moyens de contact du boitier externe via des moyens de connexion (6),
**caractérisé en ce que** les moyens de connexion et le support du composant électronique sont agencés de sorte que ledit support est suspendu par lesdits moyens de connexion afin que ledit support reste mobile.

2. Dispositif selon la revendication 1, **caractérisé en ce que** les moyens de connexion comprennent au moins un fil électriquement conducteur (6).

3. Dispositif selon la revendication 1, **caractérisé en ce que** les moyens de connexion comprennent au moins un circuit imprimé flexible (6a).

4. Dispositif selon la revendication 1**, caractérisé en ce que** le support (5) et le boîtier externe (3) sont reliés électriquement par soudage sur bande.

5. Dispositif selon l'une des revendications 1 à 4, **caractérisé en ce que** le support est un boîtier interne (5) à l'intérieur duquel se trouve le composant électronique.

6. Dispositif selon la revendication 5, **caractérisé en ce que** le boîtier interne est réalisé en matériau céramique.

7. Dispositif selon l'une des revendications 5 ou 6, **caractérisé en ce que** des moyens d'amortissement supplémentaires (13) sont agencés dans le boîtier externe (3) pour amortir ledit boîtier interne (5).

8. Dispositif selon la revendication 7**, caractérisé en ce que** les moyens d'amortissement supplémentaires comprennent au moins une couche de matériaux élastiques disposée entre le fond du boîtier externe (3) et la surface d'appui du boîtier interne (5).

9. Dispositif selon la revendication 8, **caractérisé en ce que** le matériau élastique utilisé se présente sous la forme de gel.

10. Dispositif selon la revendication 7, **caractérisé en ce que** les moyens d'amortissement supplémentaires comprennent au moins deux éléments (13) en matériaux élastiques agencés pour s'emboiter dans le boîtier interne (5) au niveau de sa tranche de sorte que ledit boîtier interne se trouve en appui sur le fond du boitier externe par l'intermédiaire des au moins deux éléments en matériaux élastiques.

11. Dispositif selon la revendication 10, **caractérisé en ce que** le matériau élastique utilisé est du silicone.

12. Dispositif selon l'une des revendications 1 à 4, **caractérisé en ce que** le support est une plaque (5a) sur la surface de laquelle est fixé le composant électronique.

13. Dispositif selon la revendication 12, **caractérisé en ce que** la plaque (5a) comporte à chaque extrémité angulaire, une saillie (15) s'étendant transversalement, deux saillies d'un même coté par rapport à l'axe longitudinal du support définissant alors un espace libre permettant à un circuit imprimé flexible (6a) de s'y loger, ledit circuit imprimé flexible étant électriquement relié à ladite plaque par au moins une plage de connexion agencée sur chacune des saillies, l'ensemble support et circuit imprimé flexible étant soutenu par au moins deux excroissances (10) agencées au niveau du boîtier externe, ces au moins deux excroissances permettant ainsi de relier électriquement la plaque et les pattes du boîtier externe (3) via au moins une plage de contact (4a) agencée sur chacune des excroissances.

14. Dispositif selon la revendication 13, **caractérisé en ce que** les au moins deux excroissances (10) sont agencés en vis-à-vis par rapport à l'axe longitudinal du boîtier externe (3).

15. Dispositif selon l'une des revendications 13 ou 14, **caractérisé en ce que** les au moins deux excroissances (10) sont situé à mi-distance de la longueur totale du boîtier externe.

16. Dispositif selon l'une quelconque des revendications précédentes, **caractérisé en ce qu'**un routage électrique (12) est agencé sur l'une des faces du support de sorte que des composants électroniques secondaires (11) puissent y être fixés.

17. Dispositif selon l'une quelconque des revendications précédentes, **caractérisé en ce que** les moyens de contacts (4) sont des pattes.

18. Dispositif selon l'une des revendications précédentes, **caractérisé en ce que** le boitier externe comprend au moins une plage de contact (7) située sur l'un de ses flanc interne et connectée aux moyens de contacts (4), permettant de relié lesdits moyens de contact du boîtier externe à la au moins une plage de contact (8) du support via les moyens de connexion.

19. Dispositif selon l'une des revendications précédentes, **caractérisé en ce que** le composant électronique fixé audit support est un résonateur ou un gyroscope.
